# EUROPÄISCHE PATENTSCHRIFT

(11) **EP 3 109 963 B1**
(45) Veröffentlichungstag und Bekanntmachung des Hinweises auf die Patenterteilung: **18.04.2018**
(21) Anmeldenummer: 16175198.7
(22) Anmeldetag: 20.06.2016
(51) Int. Cl.: H02G 15/10, H02G 15/103

(54) **HOCHSPANNUNGSVERBINDER**
HIGH VOLTAGE CONNECTOR
CONNECTEUR HAUTE TENSION

(30) Priorität: 22.06.2015 DE 102015007882
(43) Veröffentlichungstag der Anmeldung: 28.12.2016
(73) Patentinhaber: Tesat Spacecom GmbH & Co. KG, 71522 Backnang (DE)
(72) Erfinder: Müller, Michael Eberhard, 71642 Ludwigsburg (DE); Jaumann, Günther, 70374 Stuttgart (DE); Spies, Marc, 70771 Leinfelden-Echterdingen (DE); Schneider, Dieter, 71522 Backnang (DE)
(74) Vertreter: LKGLOBAL Lorenz & Kopf PartG mbB Patentanwälte

(56) Entgegenhaltungen:
- EP-A1- 1 206 004
- DE-A1-102010 029 374
- DE-B3-102005 017 472
- US-A- 5 804 767

## Beschreibung

### Technisches Gebiet

Die Erfindung betrifft einen Hochspannungsverbinder zum Herstellen einer elektrischen Verbindung zwischen zwei Hochspannungsleitungen, einen Wanderfeldröhrenverstärker mit einem solchen Hochspannungsverbinder sowie einen Satelliten mit einem solchen Wanderfeldröhrenverstärker.

### Hintergrund der Erfindung

Auf Satellitenplattformen in Umlaufbahnen um die Erde oder anderen Weltraummissionen werden in der Regel Wanderfeldröhrenverstärker als Bestandteil einer Signalübertragungsstrecke oder einer Kommunikationsverbindung eingesetzt. Die Wanderfeldröhrenverstärker bestehen im Wesentlichen aus einer Wanderfeldröhre (auch: traveling wave tube, TWT) und einer Stromversorgung (auch: electronic power conditioner, EPC). TWT und EPC sind mit einem Hochspannungskabel (HV-Kabel, high voltage) miteinander verbunden. Das HV-Kabel ist in der TWT integraler Bestandteil, weil die hohen Spannungen eine elektrische Verbindung von hoher Güte erfordern, d.h. insbesondere dass die elektrische Verbindung unempfindlich gegen äußere elektromagnetische Einflüsse ist. Das HV-Kabel kann nach Integration in die TWT nur mit sehr hohem Aufwand oder gar nicht gewechselt werden. Insbesondere bei zu kurzen HV-Kabellängen oder bei der HV-Kabel Reparatur kann damit ein hoher Aufwand entstehen. Ein EPC ist eine DC-Stromversorgung, die üblicherweise aus einer Gleichspannung bis zu 100 Volt mehrere DC-Hochspannungen bis hin zu 10 kV erzeugt. Eine Wanderfeldröhre nutzt die DC-Hochspannung, um ein Hochfrequenzsignal zu verstärken.

Von Hochspannung wird ab einer Spannung von 1000 Volt oder 1 kV gesprochen. Bei diesen Spannungswerten stellen sich physikalische Phänomene in den Leitungen ein, die nicht mit denjenigen bei Verwendung von niedrigeren Spannungen vergleichbar sind. So besteht beispielsweise eine besonders hohe Überschlagsgefahr zwischen Leitungen mit unterschiedlichen Spannungspotenzialen oder zwischen Leitungen und Masse, insbesondere im Zwischendruck. Eine Verlängerung eines Hochspannungskabels wird gemeinhin als nicht hinzunehmende Schwächung der Systemeigenschaften betrachtet, so dass üblicherweise ein durchgängiges Hochspannungskabel für die Anbindung von entsprechenden Komponenten verwendet wird. Aus diesem Grund stellt es sich als besondere Herausforderung dar, wenn ein Hochspannungskabel sich nach dem Zusammenbau einer Hochspannungskomponente als zu kurz herausstellt, weil sich beispielsweise die Systemumgebung verändert hat oder auch aus anderen Gründen. Die DE102005017472 offenbart einen Hochspannungsverbinder nach dem Oberbegriff des Anspruchs 1.

### Zusammenfassung der Erfindung

Es kann als Aufgabe der Erfindung betrachtet werden, eine Möglichkeit zur Verbindung von Hochspannungsleitungen bereitzustellen, insbesondere für die Verwendung im Vakuum und in der Schwerelosigkeit, wie z.B. in erdfernen Satelliten Diese Aufgabe wird gelöst durch den Gegenstand des unabhängigen Anspruchs. Weiterbildungen der Erfindung ergeben sich aus den abhängigen Ansprüchen und aus der folgenden Beschreibung.

Gemäß einem Aspekt der Erfindung ist ein Hochspannungsverbinder zum Herstellen einer Hochspannungsverbindung zwischen zwei Hochspannungsleitungen angegeben. Der Hochspannungsverbinder weist ein Trägerelement mit einer ersten Führungsrille und einer zweiten Führungsrille auf, wobei das Trägerelement ein hochspannungsisolierendes Material aufweist, wobei die erste Führungsrille und die zweite Führungsrille parallel zueinander angeordnet sind und sich in Längsrichtung des Trägerelements erstrecken und wobei die erste Führungsrille und die zweite Führungsrille ausgeführt sind, jeweils eine Ader einer ersten Hochspannungsleitung und einer zweiten Hochspannungsleitung aufzunehmen.

Der Hochspannungsverbinder ist insbesondere für die Verwendung mit Hochspannung vorgesehen, d.h. für Spannungen von mindestens 1 kV, in einer Ausführungsform für Hochspannungen von 4 kV oder 6kV, bis hin zu 10 kV. Eine Hochspannungsleitung kann mehrere Adern aufweisen, die jeweils als elektrischer Leiter ausgeführt sind und gegenüber den anderen Adern elektrisch isoliert sind.

Führungsrillen sind Ausnehmungen oder Vertiefungen in einer Oberfläche des Trägerelements, so dass darin eine Ader einer Hochspannungsleitung angeordnet werden kann. Beim Herstellen einer Hochspannungsverbindung zwischen den Enden von zwei einander entsprechenden Adern in miteinander zu verbindenden Hochspannungsleitungen werden die Endabschnitte der Adern zunächst abisoliert und elektrisch miteinander verbunden. Die Verbindungsstelle kann durch Nutzung von Verbindungszusatzstoffen (wie z.B. Lot) mechanisch gefestigt werden. In anderen Worten wird jeweils ein Adernpaar der beiden Hochspannungsleitungen miteinander so verbunden, dass eine elektrische Verbindung entsteht, somit kann beispielsweise eine bestehende Hochspannungsleitung verlängert werden. Abschließend wird eine Isolation um die Verbindungsstelle angebracht, beispielsweise in Form einer Schrumpfhülse. Das Herstellen einer solchen Verbindung kann auch als spleißen bezeichnet werden.

Die gespleißte Verbindungsstelle eines Adernpaares wird in einer Führungsrille des Trägerelements angeordnet. Die Verbindungsstelle kann gerade bei einer Hochspannungsverbindung eine mechanische und elektromagnetische Schwachstelle der Ader darstellen, weil die Spleißstelle mechanisch schwächer sein kann, als eine einstückige und durchgehende Ader und weil die nachträglich hinzugefügte Isolation andere Isolationseigenschaften haben kann, als die ursprüngliche Isolation einer Ader.

Die Verbindungsstelle wird in einer Führungsrille angeordnet und mechanisch an diesem Ort fixiert. Damit kann insbesondere sichergestellt werden, dass sich bei mehreren verbundenen Adernpaaren die Verbindungsstellen nicht relativ zueinander bewegen. Ein bestimmter Abstand zwischen den Verbindungsstellen kann eingehalten werden. Außerdem kann so gewährleistet werden, dass die Adern sich nicht durch eine Relativbewegung gegenseitig beschädigen, z.B. kann verhindert werden, dass die Spleißstellen gegenseitig die Isolationsschicht durch eine Scheuer- oder Reibbewegung abtragen und schwächen.

Das Trägerelement kann eine Mehrzahl von Führungsrillen aufweisen, wobei die Anzahl der Führungsrillen auf die Anzahl der Adern der zu verbindenden Hochspannungsleitungen angepasst sein kann. So kann das Trägerelement in einer Ausführungsform beispielsweise zwölf Führungsrillen aufweisen, um Hochspannungsleitungen mit jeweils zwölf Adern miteinander zu verbinden. Wenn eine Hochspannungsverbindung zwischen zwei HV-Leitungen hergestellt wird, können z.B. Adernpaare mit dem größten Potentialunterschied so in Führungsrillen des Trägerelements angeordnet werden, dass diese den größten Abstand zueinander haben. Dies kann die Gefahr eines Spannungsüberschlags reduzieren.

Hochspannungsisolierendes Material im Sinne dieser Beschreibung ist ein Material, welches ausgeführt und geeignet ist, die Gefahr eines Spannungsüberschlags zwischen benachbarten Adern der verbundenen Hochspannungsleitungen zu reduzieren oder zu verhindern; benachbarte Adern sind dabei solche Adern, welche gerade keine elektrische Verbindung zueinander haben, also nicht die jeweils zwei Adern der beiden Hochspannungsleitungen, welche elektrisch miteinander verbunden sind. Als hochspannungsisolierendes Material kann beispielsweise Noryl verwendet werden.

Die Führungsrillen verlaufen parallel und können somit gewährleisten, dass ein Abstand zwischen den darin befindlichen und miteinander verbundenen Adern in Längsrichtung des Trägerelements konstant oder im Wesentlichen konstant ist. Werden zwei Adern der Hochspannungsleitungen miteinander verbunden, kann es gerade in dem Bereich der Hochspannungsverbindung zwischen diesen beiden Adern zu einer Veränderung der Güte der Isolation kommen, weil die übliche Isolation der Adern entfernt wurde und beispielsweise über die elektrische Verbindung ein neues Isolationselement angebracht wurde. Ebenso kann es an der Spleißstelle zu einer Veränderung des Durchmessers des stromleitenden Aderkerns kommen. Diese gespleißten Stellen der Adern werden in den Führungsrillen des Trägerelements angeordnet. Durch die parallele Anordnung der Führungsrillen wird erreicht, dass die Gefahr eines Spannungsüberschlags reduziert wird und dass die Adern eine Stirnfläche des Trägerelements im Wesentlichen parallel verlaufend verlassen. Durch diesen Aufbau kann auch eine mechanische Beschädigung der Isolation der Adern verhindert werden, beispielsweise auf Grund von Reibung, welche von einer Vibration oder Erschütterung des Hochspannungsverbinders resultiert. Die Adern der miteinander verbundenen Hochspannungsleitungen werden damit erst in einem bestimmten Abstand von den Führungsrillen (und damit von den Spleißstellen) zusammengeführt und in die Hochspannungsleitungen geführt.

Gerade bei der Verwendung in Satelliten oder in anderen Raumfahrzeugen können durch den Transport in die Erdumlaufbahn und durch die Inbetriebnahme der Geräte Erschütterungen und Vibrationen stattfinden, die in starken pulsartigen Stößen resultieren können, die auf die an Bord des Raumfahrzeugs mitgeführten Geräte übertragen werden. Diese Stöße können zu Relativbewegungen der Spleißstellen führen, die sich wie oben beschrieben auswirken können. Der Hochspannungsverbinder wie hierin beschrieben reduziert das Risiko einer gegenseitigen Beschädigung der Adern und ebenfalls das Risiko eines Spannungsüberschlags, da die gespleißten Adernpaare an vorbestimmten Stellen angeordnet und relativ zueinander fixiert sind.

Der Hochspannungsverbinder ist insbesondere für eine Verwendung im Weltraum geeignet zur Verbindung von Hochspannungsleitungen für bis zu 10 kV. Der Hochspannungsverbinder kann so ausgelegt sein, dass die Vorschriften über elektromagnetische Verträglichkeit (EMV) in Satelliten eingehalten werden. Das Trägerelement kann dazu von einer geeigneten elektromagnetischen Abschirmung umgeben sein. Durch den Hochspannungsverbinder werden die gespleißten Adernpaare schock- und vibrationsresistent gehalten. Der Hochspannungsverbinder wie hierin beschrieben zeichnet sich auf Grund seines Aufbaus durch ein geringes Gesamtgewicht aus und kann beispielsweise leichter als 100 Gramm sein. Der Hochspannungsverbinder ermöglicht die Verlängerung eines HV-Kabels zwischen EPC und TWT auch nach der Integration des HV-Kabels in die TWT und ohne eine Entfernung der Kabelenden des HV-Kabels aus TWT (oder EPC). Ebenso wird es ermöglicht, ein defektes Kabel zwischen TWT und EPC zu reparieren, indem ein Abschnitt des HV-Kabels entnommen wird und ein neuer Abschnitt mittels zwei Hochspannungsverbinder eingefügt wird.

Mit dem Hochspannungsverbinder wie oben und im Folgenden beschrieben kann eine gegen elektrische Störung unempfindliche und mechanisch stabile und resistente Hochspannungsverbindung hergestellt werden.

Gemäß der Erfindung weist das Trägerelement ein erstes Führungselement auf und die Führungsrillen sind an dem ersten Führungselement angeordnet, wobei das Trägerelement ein zweites Führungselement mit mindestens einer Führungsrille aufweist, wobei das erste Führungselement an einer ersten Oberfläche des Trägerelements angeordnet ist und wobei das zweite Führungselement an einer zweiten Oberfläche des Trägerelements angeordnet ist, wobei die erste Oberfläche der zweiten Oberfläche gegenüberliegend angeordnet ist.

Damit können die Führungsrillen an zwei gegenüberliegenden Oberflächen des Trägerelements angeordnet sein. Die erste Oberfläche kann z.B. eine Oberseite des Trägerelements sein und die zweite Oberfläche die Unterseite. Wenn sowohl auf der Ober- als auch auf der Unterseite ein Führungselement mit Führungsrillen angeordnet ist, kann die Anzahl der Führungsrillen erhöht werden, um mehradrige Hochspannungsleitungen miteinander elektrisch zu verbinden.

Je nach Abstand der Führungsrillen an dem Führungselement von den Oberflächen des Trägerelements kann damit auch der Abstand zwischen den Adern auf der Ober- und Unterseite variiert werden, indem die Höhe des Führungselements an die Anforderungen angepasst wird. So kann beispielsweise beim Entwurf des Trägerelements die Höhe des Führungselements erhöht werden, um den Abstand zwischen den Adern auf Ober- und Unterseite zu erhöhen, um einen Spannungsüberschlag zwischen den Adern in den Führungsrillen auch bei höheren Spannungen zu verhindern.

Gemäß einer weiteren Ausführungsform der Erfindung weist der Hochspannungsverbinder weiterhin ein Gehäuse auf, wobei das Trägerelement mit einer Seitenfläche des Gehäuses mechanisch gekoppelt ist.

Das Gehäuse kann Aluminium oder eine Aluminiumlegierung aufweisen und dient dem Schutz des Trägerelements und der Hochspannungsverbindung vor mechanischen Einwirkungen sowie vor elektromagnetischen Einflüssen. Das Gehäuse kann so ausgeführt sein, dass die EMV-Anforderungen in einem beabsichtigten Verwendungsumfeld des Hochspannungsverbinders erfüllt werden.

Gemäß einer weiteren Ausführungsform der Erfindung weist zumindest eine Oberfläche des Gehäuses eine Öffnung auf, welche mit einem Deckel verschließbar ist.

Die Öffnung in dem Gehäuse ermöglicht einen einfachen Zugriff auf das Trägerelement, um daran die gespleißten Adern der Hochspannungsleitungen anzuordnen.

Gemäß einer weiteren Ausführungsform der Erfindung weist das Gehäuse eine Erhöhung auf, welche die Öffnung des Gehäuses zumindest teilweise umgibt.

Bei der Erhöhung, welche die Öffnung auch vollständig umgeben kann, handelt es sich um eine Stufe oder um eine erhöhte Kante, welche für den Schutz des Innenraumes des Gehäuses gegen äußere elektromagnetische Einflüsse ausgeführt ist. Diese Kante erhöht damit die EMV-Festigkeit des Gehäuses und somit den Schutz der Spleißstellen der verbundenen Aderpaare gegen äußere elektromagnetische Einflüsse.

Gemäß einer weiteren Ausführungsform der Erfindung weist das Gehäuse einen Deckel auf, welcher die Öffnung verschließt, wobei der Deckel eine Ausnehmung aufweist, welche so angeordnet ist, dass die Erhöhung in der Ausnehmung angeordnet ist, wenn der Deckel die Öffnung des Gehäuses verschließt.

Bei der Ausnehmung kann es sich beispielsweise um eine Nut oder um eine Vertiefung handeln, deren Form und Ausdehnung an die DC-Kante angepasst sein kann. Durch den Eingriff der Erhöhung in der Ausnehmung kann der Schutz vor äußeren elektromagnetischen Einflüssen verbessert werden.

Gemäß einer weiteren Ausführungsform der Erfindung weist das Trägerelement zwei Schenkel und einen Steg auf, wobei die beiden Schenkel sich in Längsrichtung des Trägerelements erstrecken und wobei der Steg sich in Querrichtung des Trägerelements erstreckt und die beiden Schenkel miteinander verbindet, wobei die Führungsrillen an dem Steg angeordnet sind.

Das Trägerelement ist damit im Wesentlichen H-förmig und die Schenkel werden von den beiden in gleicher Richtung verlaufenden Abschnitten gebildet, wobei der Steg die Querverbindung zwischen diesen beiden darstellt. Die Führungsrillen verlaufen in Richtung der Schenkel und sind an dem Steg angeordnet und die Adern verlassen die Führungsrillen in Längsrichtung des Trägerelements so, dass die Adern nicht mit einer Oberfläche des Trägerelements oder mit einer Kante einer solchen Oberfläche in Verbindung kommen, um so Beschädigungen der Aderisolation vermeiden zu können. Die Führungsrillen können insbesondere senkrecht zu dem Steg verlaufen und sich an beiden Enden des Stegs bis zu einer Stirnfläche des Stegs erstrecken. Das Führungselement kann integral mit den Steg ausgeführt sein.

Gemäß einer weiteren Ausführungsform der Erfindung ist der Steg konkav und verjüngt sich in Querrichtung des Trägerelements zur Mitte hin.

In einer Ausführungsform kann der Steg so tailliert sein, dass er in der Mitte zwischen den beiden Schenkeln die geringste Längsausdehnung aufweist

Gemäß einer weiteren Ausführungsform der Erfindung weist der Hochspannungsverbinder einen Flansch auf, welcher an einer Stirnfläche des Gehäuses angeordnet ist und ausgeführt ist, eine Hochspannungsleitung mit Bezug zu dem Gehäuse mechanisch zu fixieren.

Der Flansch kann insbesondere ausgeführt sein, eine kraftschlüssige oder reibschlüssige Verbindung mit der Hochspannungsleitung herzustellen und eine Zugentlastung der Verbindungsstellen der Adern darstellen, damit Zugkräfte, welche auf die Hochspannungsleitung wirken, nicht auf die gespleißten Stellen der Adern übertragen werden. Insbesondere kann ein Flansch an beiden Stirnflächen des Gehäuses angeordnet sein, so dass beide verbundenen Hochspannungsleitungen fixiert werden.

Gemäß einem weiteren Aspekt der Erfindung ist ein Wanderfeldröhrenverstärker angegeben, wobei der Wanderfeldröhrenverstärker eine Wanderfeldröhre, eine Stromversorgung und einen Hochspannungsverbinder wie oben und im Folgenden beschrieben aufweist, wobei der Hochspannungsverbinder eine erste Hochspannungsleitung der Wanderfeldröhre mit einer zweiten Hochspannungsleitung der Stromversorgung elektrisch verbindet.

Gemäß einer Ausführungsform des Wanderfeldröhrenverstärkers ist eine Ader der ersten Hochspannungsleitung mit einer Ader der zweiten Hochspannungsleitung in einem Spleißbereich elektrisch verbunden und der Spleißbereich ist in einer ersten Führungsrille des Trägerelements angeordnet.

Gemäß einer weiteren Ausführungsform des Wanderfeldröhrenverstärkers ist in der ersten Führungsrille eine Fixiermasse angeordnet, welche den Spleißbereich in der ersten Führungsrille fixiert.

Die Fixiermasse kann dazu dienen, Bewegungen des Spleißbereichs und der gespleißten Adernpaare relativ zu dem Trägerelement zu dämpfen und/oder zu verhindern, so dass die Gefahr einer mechanischen Beschädigung des Spleißbereichs und der Adern reduziert oder verhindert wird. Bei der Fixiermasse kann es sich beispielsweise um einen speziellen Kleber handeln, der für Anwendungen im Vakuum und in der Schwerelosigkeit geeignet ist. Die Fixiermasse kann aber auch eine gallertartige Masse sein, welche Bewegungen der Adern in der Führungsrille in einem bestimmten Maße zulässt, die Bewegungen aber dämpft.

Gemäß einer weiteren Ausführungsform des Wanderfeldröhrenverstärkers weist der Hochspannungsverbinder ein Fixiermittel auf und das Fixiermittel ist angeordnet, die Adern in der Führungsrille zu halten.

Das Fixiermittel kann beispielsweise ein Faden oder ein anderes flexibles, längliches Element sein, welches mit dem Trägerelement gekoppelt ist und so angeordnet ist, die Adern zu umgreifen so dass diese nicht aus der Führungsrille nach oben, d.h. weg von dem Trägerelement, entweichen können.

Gemäß einer weiteren Ausführungsform des Wanderfeldröhrenverstärkers ist das Fixiermittel in Längsrichtung vor und/oder hinter dem Spleißbereich angeordnet.

Damit verläuft das Fixiermittel nicht über dem Spleißbereich und auch nicht über eine am Spleißbereich zusätzlich hinzugefügte Isolierungsschicht, sondern in Längsrichtung vor bzw. hinter dem Spleißbereich. Je näher das Fixiermittel an der Stirnfläche des Führungselements angeordnet ist, desto besser kann die Fixierung der Adern erfolgen, so dass eine Bewegung der Adern relativ zu dem Trägerelement beim Verlassen der Führungsrillen zuverlässig verhindert oder reduziert werden kann. Je größer der Abstand zwischen zwei Fixierpunkten durch das Fixiermittel ist, desto besser kann auch eine Bewegung des gespleißten Adernpaares quer zu dessen Längsrichtung verhindert werden.

Gemäß einem weiteren Aspekt der Erfindung ist ein Satellit mit einem Wanderfeldröhrenverstärker wie oben und im Folgenden beschrieben.

Bei dem Satelliten kann es sich z.B. um einen Kommunikationssatelliten handeln, wobei der Wanderfeldröhrenverstärker als Bestandteil einer Kommunikationsverbindung genutzt wird.

### Kurze Beschreibung der Figuren

Im Folgenden werden mit Bezug zu den Figuren Ausführungsbeispiele der Erfindung beschrieben.
- Fig. 1: zeigt eine isometrische Darstellung eines Hochspannungsverbinders gemäß einem Ausführungsbeispiel der Erfindung;
- Fig. 2: zeigt ein Trägerelement für einen Hochspannungsverbinder gemäß einem weiteren Ausführungsbeispiel der Erfindung;
- Fig. 3: zeigt eine Schnittdarstellung eines Hochspannungsverbinders gemäß einem weiteren Ausführungsbeispiel der Erfindung;
- Fig. 4: zeigt eine schematische Darstellung eines Wanderfeldröhrenverstärkers gemäß einem weiteren Ausführungsbeispiel der Erfindung;
- Fig. 5: zeigt eine schematische Darstellung eines Wanderfeldröhrenverstärkers gemäß einem weiteren Ausführungsbeispiel der Erfindung;

### Detaillierte Beschreibung von Ausführungsbeispielen

Die Darstellungen in den Figuren sind schematisch und nicht maßstabsgetreu. Werden in den Figuren gleiche oder ähnliche Bezugszeichen verwendet, beziehen sich diese auf gleiche oder ähnliche Elemente.

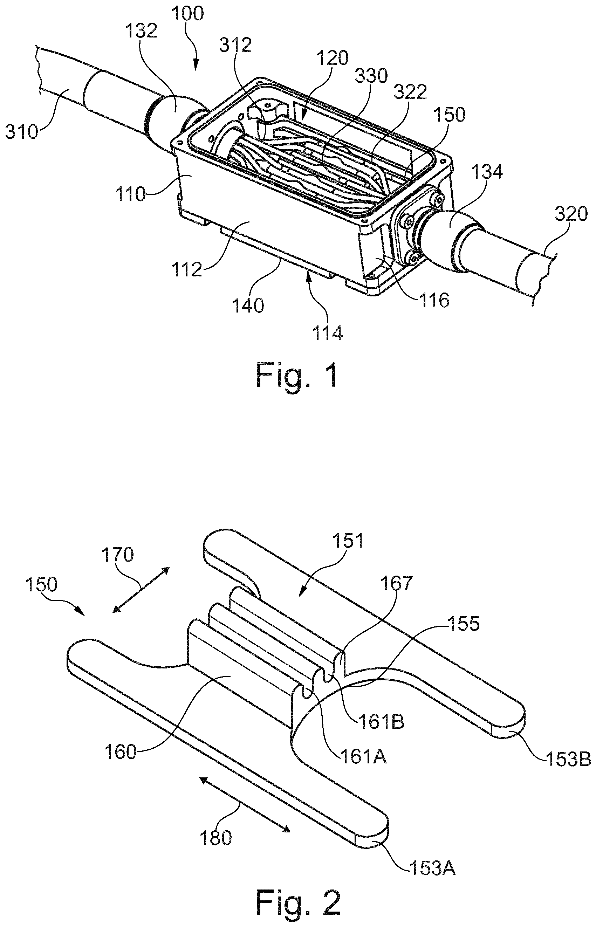

Fig. 1 zeigt einen Hochspannungsverbinder 100, welcher eine erste Hochspannungsleitung 310 mit einer zweiten Hochspannungsleitung 320 elektrisch verbindet. Der Hochspannungsverbinder 100 weist ein Gehäuse 110 auf, wobei an der Stirnfläche 116 sowie an der dieser Stirnfläche gegenüberliegenden Stirnfläche jeweils ein Flansch 132, 134 angeordnet ist, welcher jeweils eine Hochspannungsleitung 310, 320 mit Bezug zu dem Gehäuse 110 mechanisch fixiert.

In dem Innenraum 120 des Gehäuses 110, dessen obere Deckenfläche geöffnet ist, sind die Adern 312, 322 der Hochspannungsleitungen 310, 320 zu sehen. Die gespleißten Aderpaare sind an dem Verbindungsbereich oder Spleißbereich 330 mit dem Trägerelement 150 mechanisch gekoppelt bzw. an diesem fixiert. Das Trägerelement ist wiederum an Seitenflächen 112 des Gehäuses 110 befestigt.

Die Bodenfläche 114 des Gehäuses 110 ist mit einem Deckel geschlossen. Ebenso kann die offen gezeigte Deckenfläche mit einem Deckel geschlossen werden.

Das Trägerelement 150 kann insbesondere in den Ecken des Innenraums 120 mit dem Gehäuse 110 mechanisch gekoppelt sein. Insbesondere kann das Trägerelement mit einer Schraubverbindung an dem Gehäuse befestigt sein. Durch die dortige Anordnung dieser Befestigungsstellen sind die Befestigungselemente maximal weit von den Spleißstellen 330 der Adernpaare entfernt, wenn das Trägerelement mittig in dem Innenraum 120 des Gehäuses 110 angeordnet ist. Somit kann die Gefahr eines Spannungsüberschlags von den Spleißstellen auf die Befestigungselemente und/oder das Gehäuse reduziert werden.

Es ist aus Fig. 1 zu sehen, dass die gespleißten Adernpaare in dem Spleißbereich und entlang eines Abschnittes davor und dahinter parallel zueinander verlaufen, so dass der Abstand dazwischen nahezu konstant ist.

Fig. 2 zeigt eine schematische isometrische Darstellung eines Trägerelements 150. Das Trägerelement wird von zwei Schenkeln 153A, 153B und einem Steg 155 gebildet und ist im Wesentlichen H-förmig. Die Schenkel 153A, 153B verlaufen in Längsrichtung 180 und der Steg 155 in Querrichtung 170 (senkrecht zur Längsrichtung 180) des Trägerelements 150. Auf der Oberfläche 151 des Trägerelements am Steg 155 ist ein Führungselement 160 angeordnet. Das Führungselement 160 stellt einen Absatz oder eine Erhöhung auf der Oberfläche 151 dar und die Führungsrillen 161A, 161B sind auf dem Führungselement 160 angeordnet. Die Führungsrillen sind Vertiefungen, welche von Führungsrippen 162 begrenzt sind.

Es sei darauf hingewiesen, dass sich die Führungsrillen 161A, 161B auch unmittelbar auf dem Steg 155 befinden können, und zwar auf der Oberfläche 151. Das Führungselement 160 hat im Wesentlichen die Aufgabe, einen Abstand zwischen die gespleißten Adernpaare und die Oberfläche 151 zu bringen. Ein zweites Führungselement kann sich auch auf der Unterseite (gegenüberliegend der Oberfläche 151) befinden. Damit kann die Anzahl der Führungsrillen erhöht werden. Durch die Höhe der Führungselemente kann der Abstand zwischen den Adernpaaren auf der Ober- und Unterseite des Trägerelements nach Bedarf, d.h. nach notwendigem Abstand für einen Überschlagschutz, vorgegeben werden.

Die Stirnfläche 167 des Führungselements 160 schließt in diesem Ausführungsbeispiel bündig mit der Kante des Stegs 155, so dass die Adern, welche die Führungsrillen an der Stirnfläche 167 verlassen nicht mit einer weiteren Kante des Trägerelements in Berührung kommen.

Der Steg 155 kann konkav ausgeführt sein, d.h. sich ausgehend von den beiden Schenkeln zur Mitte hin verjüngen, so dass der Steg in der Mitte zwischen den beiden Schenkeln die geringste Längsausdehnung aufweist.

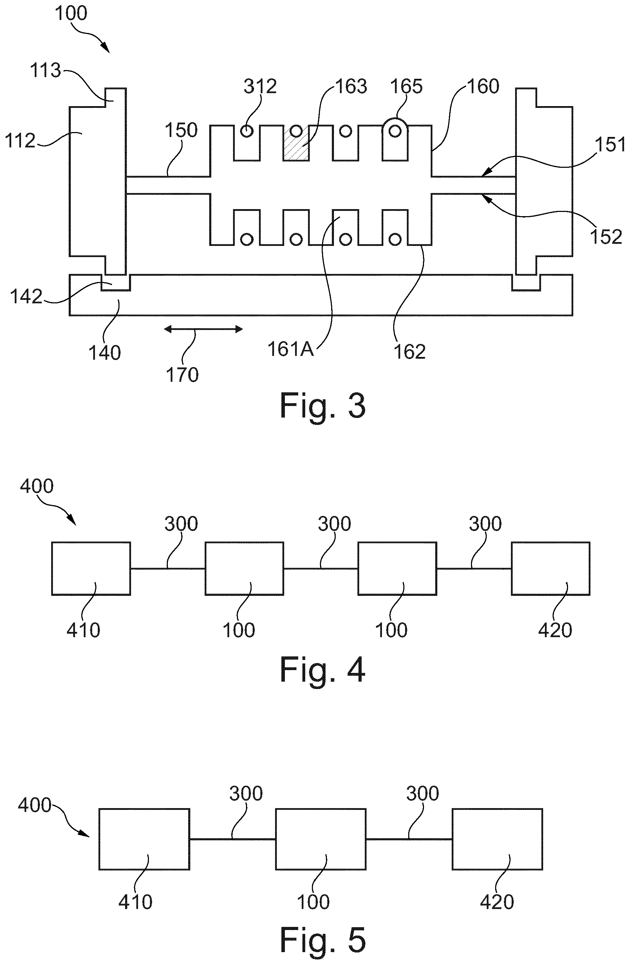

Fig. 3 zeigt eine Schnittdarstellung des Hochspannungsverbinders 100 auf Höhe der Spleißbereiche der in dem Trägerelement befindlichen Adernpaare. Links und rechts in der Darstellung sind die Seitenflächen 112 des Gehäuses 110 zu sehen. An der Unterseite ist das Gehäuse mit einem Deckel 140 geschlossen. An den oberen und unteren Enden der Seitenflächen 112 ist jeweils ein Kragen 113 angeordnet, der eine stufenartige Erhöhung auf dem Ende der Seitenfläche darstellt. Der Kragen 113 umgibt in diesem Ausführungsbeispiel die obere und untere Öffnung des Gehäuses 110 vollständig. In dem Deckel 140 befindet sich eine Ausnehmung 142, welche in ihrer Form und Ausdehnung dem Kragen 113 entspricht, so dass der Kragen 113 in der Ausnehmung aufgenommen wird, wenn der Deckel auf das Gehäuse gesetzt wird, um die entsprechende Öffnung zu verschließen.

Das Trägerelement 150 weist zwei Führungselemente 160 auf, jeweils eines an der Oberseite 151 und an der Unterseite 152. Damit ist das Trägerelement in diesem Bereich Kamm-artig bzw. Doppelkamm-artig ausgeführt. Zwischen zwei Führungsrippen 162 ist eine Führungsrille 161A angeordnet. In jeder Führungsrille ist jeweils ein gespleißtes Adernpaar 312 angeordnet. Die Führungsrillen können so bemessen sein, dass die Adernpaare zumindest teilweise, oder sogar vollständig darin aufgenommen werden, d.h. dass die Adernpaare nicht über die Führungsrippen hinausragen.

In zumindest manchen Führungsrillen kann eine Fixiermasse 163 (schraffierte Fläche) angeordnet sein, welche die darin befindlichen Adernpaare mit Bezug zu dem Trägerelement 150 fixieren und die Bewegung der Adernpaare dämpfen können. Es sei darauf hingewiesen, dass jedes Adernpaar in der zugehörigen Führungsrille mit der Fixiermasse fixiert sein kann, auch wenn dies der Übersichtlichkeit halber nur für eine Führungsrille dargestellt ist.

Zusätzlich oder alternativ zu der Fixierung mit der Fixiermasse kann ein Adernpaar in einer Führungsrille auch mit einem Fixiermittel 165 befestigt sein. Dies kann beispielsweise ein Faden sein, welcher die beiden Führungsrippen einer Führungsrille verbindet und so die dazwischen befindliche Führungsrille schließt, wenn eine Ader sich in der Führungsrille befindet. Somit kann die entsprechende Ader die Führungsrille nicht verlassen. Der Faden 165 kann also mit den beiden Führungsrippen verbunden sein, welche eine Führungsrille begrenzen.

Die Führungsrillen an der Oberseite und an der Unterseite des Trägerelements können in Querrichtung 170 des Trägerelements übereinander liegen, d.h. ohne seitlichen Versatz in Querrichtung angeordnet sein. In einem Ausführungsbeispiel können die Führungsrillen auf Ober- und Unterseite in Querrichtung zueinander versetzt sein, so dass eine Führungsrille auf der Unterseite unter einer Führungsrippe auf der Oberseite liegt und umgekehrt. Die Führungsrillen können eine ähnliche Ausdehnung in Querrichtung (Breite, in Fig. 3 von links nach rechts) haben wie die Führungsrippen. Wobei jedoch die Breite der Führungsrillen von den Ausmaßen der gespleißten Adernpaare abhängt und die Breite der Führungsrippen insbesondere von den Potentialunterschieden zwischen den Adernpaaren beeinflusst werden kann und entsprechend variiert werden kann, um einen Spannungsüberschlag zu verhindern.

Fig. 4 zeigt einen Wanderfeldröhrenverstärker 400 mit einer Wanderfeldröhre 410 und einer Stromversorgung 420 in Form eines Leistungsverstärker. An der Wanderfeldröhre 410 und an dem Leistungsverstärker ist jeweils eine Hochspannungsleitung 300 angebracht, insbesondere integral mit diesen Komponenten verbaut. Die Wanderfeldröhre und der Leistungsverstärker sind mittels zwei Hochspannungsverbindern 100 wie sie weiter oben beschrieben wurden sowie einer dazwischen befindlichen Hochspannungsleitung 300 elektrisch verbunden.

Mit diesem Aufbau kann ermöglicht werden, dass ein Wanderfeldröhrenverstärker 400 je nach Bedarf konfiguriert wird, und zwar nach der Fertigung der wesentlichen Komponenten. Dabei kann die Wanderfeldröhre mit einer Hochspannungsleitung 300 mit einer vorgegebenen Standardlänge hergestellt werden. Die Anpassung der Länge der Hochspannungsleitung zwischen der Wanderfeldröhre und dem Leistungsverstärker kann mittels des Hochspannungsverbinders und einem zusätzlichen Leitungsabschnitt erfolgen.

Fig. 5 zeigt eine alternative Ausführungsform zur Fig. 4. Dabei werden die Wanderfeldröhre 410 und die Stromversorgung 420 in Form des Leistungsverstärkers bzw. deren Hochspannungsleitungen 300 unmittelbar mit einem einzelnen Hochspannungsverbinder 100 verbunden. Diese Konfiguration kann beispielsweise gewählt werden, wenn eine Verlängerung der Leitung zwischen TWT 410 und EPC 420 nicht notwendig ist.

### Bezugszeichenliste

- 100: Hochspannungsverbinder
- 110: Gehäuse
- 112: Seitenfläche
- 113: Kragen
- 114: Bodenfläche
- 116: Stirnfläche
- 120: Innenraum
- 132: erster Flansch
- 134: zweiter Flansch
- 140: Deckel
- 142: Ausnehmung
- 150: Trägerelement
- 151: erste Oberfläche
- 152: zweite Oberfläche
- 153A: Fixierschenkel
- 153B: Fixierschenkel
- 155: Steg
- 160: Führungselement
- 161A: Führungsrille
- 161B: Führungsrille
- 162: Führungsrippe
- 163: Fixiermasse
- 165: Fixiermittel
- 167: Stirnfläche
- 170: Querrichtung
- 180: Längsrichtung
- 300: Hochspannungsleitung
- 310: erste Leitung
- 312: Ader
- 320: zweite Leitung
- 322: Ader
- 330: Verbindungsstelle, Spleiß
- 400: Wanderfeldröhrenverstärker
- 410: Wanderfeldröhre
- 420: Stromversorgung

## Patentansprüche

1. Hochspannungsverbinder (100) zum Herstellen einer Hochspannungsverbindung zwischen zwei Hochspannungsleitungen (310, 320), der Hochspannungsverbinder (100) aufweisend:
ein Trägerelement (150) mit einer ersten Führungsrille (161A) und einer zweiten Führungsrille (161B);
wobei das Trägerelement (150) ein hochspannungsisolierendes Material aufweist;
wobei die erste Führungsrille (161A) und die zweite Führungsrille (161B) sich in Längsrichtung (180) des Trägerelements (150) erstrecken;
wobei die erste Führungsrille (161A) und die zweite Führungsrille (161B) ausgeführt sind, jeweils eine Ader (312, 322) einer ersten Hochspannungsleitung (310) und einer zweiten Hochspannungsleitung (320) aufzunehmen;
**dadurch gekennzeichnet, dass**
die erste Führungsrille (161A) und die zweite Führungsrille (161B) parallel zueinander angeordnet sind;
das Trägerelement (150) ein erstes Führungselement (160) aufweist und die Führungsrillen an dem ersten Führungselement angeordnet sind;
das Trägerelement (150) ein zweites Führungselement mit mindestens einer Führungsrille aufweist;
das erste Führungselement an einer ersten Oberfläche (151) des Trägerelements (150) angeordnet ist und das zweite Führungselement an einer zweiten Oberfläche (152) des Trägerelements (150) angeordnet ist;
die erste Oberfläche (151) der zweiten Oberfläche (152) gegenüberliegend angeordnet ist.

2. Hochspannungsverbinder (100) nach Anspruch 1,
aufweisend ein Gehäuse (110),
wobei das Trägerelement (150) mit einer Seitenfläche (112) des Gehäuses (110) mechanisch gekoppelt ist.

3. Hochspannungsverbinder (100) nach Anspruch 2,
wobei zumindest eine Oberfläche des Gehäuses (110) eine Öffnung aufweist, welche mit einem Deckel (140) verschließbar ist.

4. Hochspannungsverbinder (100) nach Anspruch 3,
wobei eine Erhöhung (113) die Öffnung des Gehäuses zumindest teilweise umgibt.

5. Hochspannungsverbinder (100) nach Anspruch 4,
wobei das Gehäuse (110) einen Deckel (140) aufweist, welcher die Öffnung verschließt,
wobei der Deckel (140) eine Ausnehmung (142) aufweist, welche so angeordnet ist, dass die Erhöhung (113) in der Ausnehmung (142) angeordnet ist, wenn der Deckel (140) die Öffnung des Gehäuses (110) verschließt.

6. Hochspannungsverbinder (100) nach einem der vorhergehenden Ansprüche,
wobei das Trägerelement (150) zwei Schenkel (153A, 153B) und einen Steg (155) aufweist;
wobei die beiden Schenkel (153A, 153B) sich in Längsrichtung (180) des Trägerelements erstrecken und wobei der Steg (155) sich in Querrichtung (170) des Trägerelements erstreckt und die beiden Schenkel (153A, 153B) miteinander verbindet;
wobei die Führungsrillen (161A, 161B) an dem Steg (155) angeordnet sind.

7. Hochspannungsverbinder (100) nach Anspruch 6,
wobei der Steg (155) konkav ist und sich in Querrichtung (170) des Trägerelements (150) zur Mitte hin verjüngt.

8. Hochspannungsverbinder (100) nach einem der Ansprüche 2 bis 7,
aufweisend einen Flansch (132), welcher an einer Stirnfläche (116) des Gehäuses angeordnet ist und ausgeführt ist, eine Hochspannungsleitung (310, 320) mit Bezug zu dem Gehäuse mechanisch zu fixieren.

9. Wanderfeldröhrenverstärker (400), aufweisend
eine Wanderfeldröhre (410);
eine Stromversorgung (420); und
einen Hochspannungsverbinder (100) nach einem der vorhergehenden Ansprüche;
wobei der Hochspannungsverbinder (100) eine erste Hochspannungsleitung (310) der Wanderfeldröhre (410) mit einer zweiten Hochspannungsleitung (320) der Stromversorgung (420) verbindet.

10. Wanderfeldröhrenverstärker (400) nach Anspruch 9,
wobei eine Ader (312) der ersten Hochspannungsleitung (310) mit einer Ader (322) der zweiten Hochspannungsleitung (320) in einem Spleißbereich elektrisch verbunden ist und wobei der Spleißbereich in einer ersten Führungsrille (161A) des Trägerelements (150) angeordnet ist.

11. Wanderfeldröhrenverstärker (400) nach Anspruch 10,
wobei in der ersten Führungsrille (161A) eine Fixiermasse (163) angeordnet ist, welche den Spleißbereich in der ersten Führungsrille (161A) fixiert.

12. Wanderfeldröhrenverstärker (400) nach einem der Ansprüche 10 oder 11,
wobei ein Fixiermittel (165) angeordnet ist, die Adern (312, 322) in der Führungsrille zu halten.

13. Wanderfeldröhrenverstärker (400) nach Anspruch 12,
wobei das Fixiermittel (165) in Längsrichtung vor oder hinter dem Spleißbereich angeordnet ist.

14. Satellit mit einem Wanderfeldröhrenverstärker (400) nach einem der Ansprüche 9 bis 13.

## Claims

1. High voltage connector (100) for establishing a high voltage connection between two high voltage lines (310, 320), with the high voltage connector (100) comprising:
a carrier element (150) with a first guiding groove (161A) and a second guiding groove (161B);
wherein the carrier element (150) comprises a high voltage insulating material;
wherein the first guiding groove (161A) and the second guiding groove (161B) extend in a longitudinal direction (180) of the carrier element (150);
wherein each of the first guiding groove (161A) and the second guiding groove (161B) is designed for accommodating a wire (312, 322) of each of a first high voltage line (310) and a second high voltage line (320);
**characterized in that**
the first guiding groove (161A) and the second guiding groove (161B) are arranged parallel to one another;
the carrier element (150) comprises a first guiding element (160) and the guiding grooves are arranged on the first guiding element;
the carrier element (150) comprises a second guiding element with at least one guiding groove;
the first guiding element is arranged on a first surface (151) of the carrier element (150) and the second guiding element is arranged on a second surface (152) of the carrier element (150);
the first surface (151) is arranged opposite to the second surface (152).

2. High voltage connector (100) of claim 1,
comprising a housing (110),
wherein the carrier element (150) is mechanically coupled with a lateral surface (112) of the housing (110).

3. High voltage connector (100) of claim 2,
wherein at least one surface of the housing (110) comprises an opening that can be closed with a cover (140).

4. High voltage connector (100) of claim 3,
wherein a raised section (113) at least partially surrounds the opening of the housing.

5. High voltage connector (100) of claim 4,
wherein the housing (110) comprises a cover (140) that closes the opening,
wherein the cover (140) comprises a recess (142) that is arranged such that the raised section (113) is positioned within the recess (142) when the cover (140) closes the opening of the housing (110).

6. High voltage connector (100) of one of the preceding claims,
wherein the carrier element (150) comprises two legs (153A, 153B) and a crosspiece (155);
wherein the two legs (153A, 153B) extend in the longitudinal direction (180) of the carrier element and wherein the crosspiece (155) extends in the lateral direction (170) of the carrier element and connects the two legs (153A, 153B) to one another;
wherein the guiding grooves (161A, 161B) are arranged on the crosspiece (155).

7. High voltage connector (100) of claim 6,
wherein the crosspiece (155) is concave and tapered toward the center in the lateral direction (170) of the carrier element (150).

8. High voltage connector (100) of one of claims 2 to 7,
comprising a flange (132) that is arranged on an end face (116) of the housing and designed for mechanically fixing a high voltage line (310, 320) relative to the housing.

9. Traveling-wave tube amplifier (400), comprising
a traveling-wave tube (410);
a power supply (420); and
a high voltage connector (100) of one of the preceding claims;
wherein the high voltage connector (100) connects a first high voltage line (310) of the traveling-wave tube (410) to a second high voltage line (320) of the power supply (420).

10. Traveling-wave tube amplifier (400) of claim 9,
wherein a wire (312) of the first high voltage line (310) is electrically connected to a wire (322) of the second high voltage line (320) in a splicing region and wherein the splicing region is arranged in a first guiding groove (161A) of the carrier element (150).

11. Traveling-wave tube amplifier (400) of claim 10,
wherein a fixing mass (163) is arranged in the first guiding groove (161A) and fixes the splicing region in the first guiding groove (161A).

12. Traveling-wave tube amplifier (400) of one of claims 10 or 11,
wherein a fixing means (165) is arranged such that it holds the wires (312, 322) in the guiding groove.

13. Traveling-wave tube amplifier (400) of claim 12,
wherein the fixing means (165) is arranged in front of or behind the splicing region referred to the longitudinal direction.

14. Satellite with a traveling-wave tube amplifier (400) of one of claims 9 to 13.

## Revendications

1. Connecteur haute tension (100) pour établir une connexion haute tension entre deux lignes haute tension (310, 320), avec le connecteur haute tension (100) comprenant:
un élément de support (150) avec une première rainure de guidage (161A) et une seconde rainure de guidage (161B);
dans lequel l'élément de support (150) comprend un matériau isolant à haute tension;
dans lequel la première rainure de guidage (161A) et la seconde rainure de guidage (161B) s'étendent dans une direction longitudinale (180) de l'élément de support (150);
dans lequel chacune de la première rainure de guidage (161A) et de la deuxième rainure de guidage (161B) est conçue pour recevoir un fil (312, 322) d'une première ligne haute tension (310) et d'une seconde ligne haute tension (320);
**caractérisé en ce que**
la première rainure de guidage (161A) et la seconde rainure de guidage (161B) sont disposées parallèlement les unes aux autres;
l'élément de support (150) comprend un premier élément de guidage (160) et les rainures de guidage sont agencées sur le premier élément de guidage;
l'élément de support (150) comprend un second élément de guidage avec au moins une rainure de guidage;
le premier élément de guidage est disposé sur une première surface (151) de l'élément de support (150) et le second élément de guidage est disposé sur une seconde surface (152) de l'élément de support (150);
la première surface (151) est disposée en face de la seconde surface (152).

2. Connecteur haute tension (100) selon la revendication 1,
comprenant un boîtier (110),
dans lequel l'élément de support (150) est couplé mécaniquement à une surface latérale (112) du boîtier (110).

3. Connecteur haute tension (100) selon la revendication 2,
dans lequel au moins une surface du boîtier (110) comprend une ouverture qui peut être fermée avec un couvercle (140).

4. Connecteur haute tension (100) selon la revendication 3,
dans lequel une section surélevée (113) entoure au moins partiellement l'ouverture du boîtier.

5. Connecteur haute tension (100) selon la revendication 4,
dans lequel le boîtier (110) comprend un couvercle (140) qui ferme l'ouverture,
dans lequel le couvercle (140) comprend un évidement (142) qui est agencé de telle sorte que la section surélevée (113) est positionnée à l'intérieur de l'évidement (142) lorsque le couvercle (140) ferme l'ouverture du logement (110).

6. Connecteur haute tension (100) selon l'une des revendications précédentes, dans lequel l'élément de support (150) comprend deux branches (153A, 153B) et une traverse (155);
dans lequel les deux branches (153A, 153B) s'étendent dans la direction longitudinale (180) de l'élément de support et dans lequel la traverse (155) s'étend dans la direction latérale (170) de l'élément de support et relie les deux branches (153A, 153B) à une autre;
dans lequel les rainures de guidage (161A, 161B) sont agencées sur la traverse (155).

7. Connecteur haute tension (100) selon la revendication 6,
dans lequel la traverse (155) est concave et effilée vers le centre dans la direction latérale (170) de l'élément de support (150).

8. Connecteur haute tension (100) selon l'une des revendications 2 à 7,
comprenant une bride (132) qui est agencée sur une face d'extrémité (116) du boîtier et conçue pour fixer mécaniquement une ligne haute tension (310, 320) par rapport au boîtier.

9. Amplificateur à tube à ondes progressives (400), comprenant
un tube à ondes progressives (410);
une alimentation électrique (420); et
un connecteur haute tension (100) selon l'une des revendications précédentes;
dans lequel le connecteur haute tension (100) connecte une première ligne haute tension (310) du tube à ondes progressives (410) à une seconde ligne haute tension (320) de l'alimentation électrique (420).

10. Amplificateur à tube à ondes progressives (400) selon la revendication 9,
dans lequel un fil (312) de la première ligne haute tension (310) est connecté électriquement à un fil (322) de la seconde ligne haute tension (320) dans une région d'épissage et dans lequel la région d'épissage est agencée dans une première rainure de guidage (161A) de l'élément de support (150).

11. Amplificateur à tube à ondes progressives (400) selon la revendication 10,
dans lequel une masse de fixation (163) est agencée dans la première rainure de guidage (161A) et fixe la région d'épissage dans la première rainure de guidage (161A).

12. Amplificateur à tube à ondes progressives (400) selon l'une des revendications 10 ou 11,
dans lequel un moyen de fixation (165) est agencé de telle sorte qu'il retient les fils (312, 322) dans la rainure de guidage.

13. Amplificateur à tube à ondes progressives (400) selon la revendication 12,
dans lequel les moyens de fixation (165) sont disposés devant ou derrière la région d'épissage en se référant à la direction longitudinale.

14. Satellite avec amplificateur à tube à ondes progressives (400) selon l'une des revendications 9 à 13.
